(19) Europäisches Patentamt

European Patent Office

Office européen des brevets

(11) **EP 1 715 590 A1**

## (12) EUROPEAN PATENT APPLICATION

(43) Date of publication:
**25.10.2006 Bulletin 2006/43**

(51) Int Cl.:
***H03M 13/11*** (2006.01)    ***H03M 13/29*** (2006.01)

(21) Application number: **06007306.1**

(22) Date of filing: **06.04.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **06.04.2005 KR 20050028573**

(71) Applicants:
- **Samsung Electronics Co., Ltd.**
  **Suwon-si, Gyeonggi-Do (KR)**
- **Yonsei University**
  **Seodaemun-gu, Seoul (KR)**

(72) Inventors:
- **Kim, Joon-Sung**
  **c/o Samsung Electronics Co., Ltd.**
  **Suwon-si**
  **Gyeonggi-do (KR)**

- **Song, Hong-Yeop**
  **c/o Samsung Electronics Co., Ltd.**
  **Suwon-si**
  **Gyeonggi-do (KR)**
- **Kim, Dong-Ho**
  **c/o Samsung Electronics Co., Ltd.**
  **Suwon-si**
  **Gyeonggi-do (KR)**
- **You, Cheol-Woo**
  **c/o Samsung Electronics Co., Ltd.**
  **Suwon-si**
  **Gyeonggi-do (KR)**
- **Lee, Ye-Hoon**
  **c/o Samsung Electronics Co., Ltd.**
  **Suwon-si**
  **Gyeonggi-do (KR)**

(74) Representative: **Grünecker, Kinkeldey,**
**Stockmair & Schwanhäusser**
**Anwaltssozietät**
**Maximilianstrasse 58**
**80538 München (DE)**

(54) **Method for encoding/decoding concatenated LDGM code**

(57)     A decoding method in a concatenated low-density generator matrix (LDGM) code-based transmission system for detecting a signal using a parity check matrix including a systematic bit part mapped to systematic bits and a parity check part mapped to parity bits. The decoding method includes generating an outer code parity check matrix with a predetermined size using a pseudorandom algorithm; generating an inner code parity check matrix using the outer code parity check matrix; and decoding a received signal using the inner code parity check matrix.

FIG.2

EP 1 715 590 A1

**Description**

The present invention relates generally to channel encoding in a communication system, and in particular, to a low-density generator matrix (LDGM) code encoding/decoding method for minimizing encoding/decoding complexity to improve its performance.

In general, a turbo code has a very low encoding complexity but has a high decoding complexity, whereas a low-density parity check (LDPC) code has a high encoding complexity but has a very low decoding complexity, compared with the turbo code.

The LDPC code, which is a linear code having a parity check matrix including a small number of' '1's, uses a probabilistic iterative decoding algorithm and exhibits performance approaching the Shannon's channel capacity limit. An advantage of the LDPC code over the turbo code consists in the parallel decoder structure, capable of high-speed decoding. However, the LDPC code is much higher than the turbo code in encoding complexity because its encoding process includes complex matrix multiplication.

A low-density generator matrix (LDGM) code is superior to the standard LDPC code and turbo code in terms of complexity. In particular, the LDGM code, because of the sparse structure of its generator matrix, is linear with respect to block size like the turbo code, for the throughput required in the encoding process.

In addition, the LDGM code, which actually is a subset of the LDPC code, can perform decoding using the same method and with the same complexity as those of the standard LDPC code, because the parity check matrix of a structured LDGM code is also sparse.

Equation (1) and Equation (2) below show a parity check matrix and a generator matrix of a standard LDGM code, respectively.

$$H = \begin{bmatrix} 1 & 0 & 1 & 1 & 0 & 1 & 1 & 0 & 0 \\ 1 & 1 & 0 & 1 & 1 & 0 & 0 & 1 & 0 \\ 0 & 1 & 1 & 0 & 1 & 1 & 0 & 0 & 1 \end{bmatrix} \qquad \ldots\ldots\ldots\ldots (1)$$

$$G = \begin{bmatrix} 1 & 0 & 0 & 0 & 0 & 0 & 1 & 1 & 0 \\ 0 & 1 & 0 & 0 & 0 & 0 & 0 & 1 & 1 \\ 0 & 0 & 1 & 0 & 0 & 0 & 1 & 0 & 1 \\ 0 & 0 & 0 & 1 & 0 & 0 & 1 & 1 & 0 \\ 0 & 0 & 0 & 0 & 1 & 0 & 0 & 1 & 1 \\ 0 & 0 & 0 & 0 & 0 & 1 & 1 & 0 & 1 \end{bmatrix} \qquad \ldots\ldots\ldots\ldots (2)$$

As shown in Equation (1) and Equation (2), the parity check matrix and the generator matrix of the LDGM code are sparse in that most of their elements are '0'. Therefore, a decoder for the LDGM code can be constructed in the method used for designing a decoder for the LDPC code. An encoder for the LDGM code also has a very low complexity because the generator matrix has a small number of '1's.

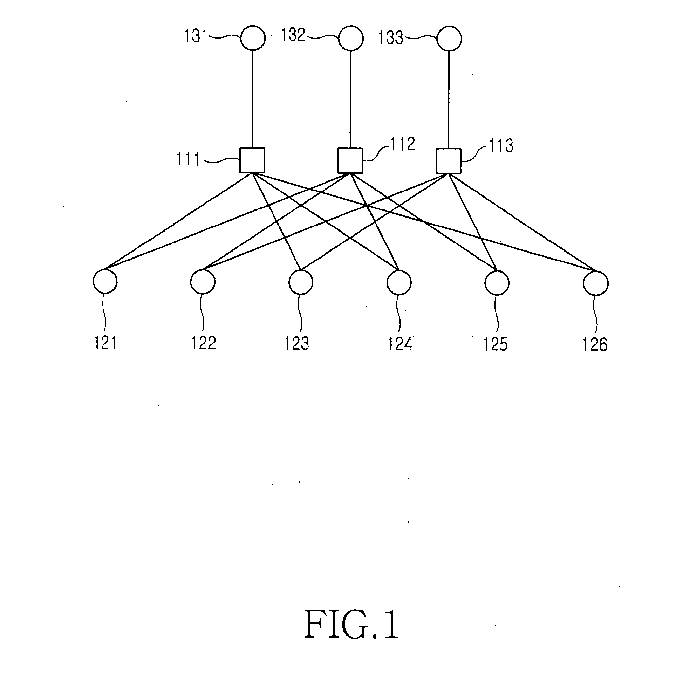

FIG. 1 is a bipartite graph expressing the parity check matrix of Equation (1). In FIG. 1, a first check node 111 is connected to first, third, fourth and sixth bit nodes 121, 123, 124 and 126, and a first coded bit node 131 constituting a parity part of the parity check matrix. A second check node 112 is connected to first, second, fourth and fifth bit nodes 121, 122, 124 and 125, and a second coded bit node 132. A third check node 113 is connected to second, third, fifth and sixth bit nodes 122, 123, 125 and 126, and a third coded bit node 133.

However, because there are bit nodes connected only to one check node as shown in the bipartite graph of the parity check matrix, an error floor occurs causing a dramatic reduction in bit error rate (BER) performance. In order to address the disadvantage, a concatenated LDGM code has been proposed which uses two different LDGM codes as an inner code and an outer code, thereby showing performance approaching the Shannon's channel capacity limit.

Further, the concatenated LDGM code increases encoding and decoding complexity because it uses two encoders and two decoders.

It is, therefore, the object of the present invention to provide a concatenated LDGM code encoding/decoding method for reducing complexity of a decoder.

This object is solved by the subject matter of the independent claims.

Preferred embodiments are defined by the subject matter of the dependent claims.

According to one aspect of the present invention, there is provided a decoding method in a concatenated low-density generator matrix (LDGM) code-based transmission system for detecting a signal using a parity check matrix including a systematic bit part mapped to systematic bits and a parity check part mapped to parity bits. The decoding method includes generating an outer code parity check matrix with a predetermined size using a pseudorandom algorithm; generating an inner code parity check matrix using the outer code parity check matrix; and decoding a received signal using the inner code parity check matrix.

Preferably, the outer code parity check matrix generating step includes generating a first systematic bit part with a predetermined size using the pseudorandom algorithm; and adding a first parity check part in the form of an identity matrix with the same row size, to the first systematic bit part.

Preferably, the inner code parity check matrix generating step includes extending each row of the first systematic bit part of the outer code parity check matrix to a partial matrix with a predetermined row size; extending the first parity check part using the pseudorandom algorithm; generating a second systematic bit part of the inner code parity check matrix by arranging the extended partial matrixes and the extended first parity check parts; and adding a second parity check part in the form of an identity matrix with the same row size, to the second systematic bit part.

According to another aspect of the present invention, there is provided an encoding method in a concatenated low-density generator matrix (LDGM) code-based transmission system for detecting a signal using a parity check matrix including a systematic bit part mapped to systematic bits and a parity check part mapped to parity bits. The encoding method includes generating an outer code parity check matrix with a predetermined size using a pseudorandom algorithm; generating an inner code parity check matrix using the outer code parity check matrix; generating a generator matrix using the inner code parity check matrix; and concatenatively-encoding a transmission signal using the generator matrix.

According to further another aspect of the present invention, there is provided a low-density generator matrix (LDGM) decoder in a concatenated LDGM code-based transmission system using an inner LDGM code and an outer LDGM code, wherein the LDGM decoder groups a plurality of parity check nodes constituting a parity check matrix of the inner LDGM code and uses the parity check node groups as check nodes of the parity check matrix.

Preferably, the parity check matrix of the outer LDGM code includes a first systematic bit part with a predetermined size, generated using a pseudorandom algorithm; and a first parity check part having the same row size as that of the first systematic bit part.

Preferably, the parity check matrix of the inner LDGM code includes a second systematic bit part including first partial matrixes generated by extending each row of the first systematic bit part in a predetermined size and second partial matrixes generated by extending the first parity check matrix using a pseudorandom algorithm; and a second parity check part in the form of an identity matrix having the same row size as that of the second systematic bit part.

The present invention will become more apparent from the following detailed description when taken in conjunction with the accompanying drawings in which:

FIG. 1 is a bipartite graph expressing a parity check matrix of a general LDGM code;

FIG. 2 is a conceptual diagram of a process of generating a parity check matrix in an LDGM code encoding/decoding method according to the present invention;

FIG. 3A is a bipartite graph for a first row of the systematic bit part of the outer parity check matrix shown in FIG. 2;

FIG. 3B is a bipartite graph for the matrix generated by extending the first row of the systematic bit part of the outer parity check matrix shown in FIG. 2;

FIG. 3C is a bipartite graph for a description of a process of integrating the check codes extended in the bipartite graph of FIG. 3B;

FIG. 3D is a bipartite graph given after integration of the check nodes extended in the bipartite graph of FIG. 3B;

FIG. 4 is a conceptual diagram illustrating an improved belief-propagation algorithm applied to an LDGM code encoding/decoding method according to the present invention;

FIG 5 is a block diagram schematically illustrating a structure of a concatenated LDGM decoder implemented by applying an LDGM code encoding/decoding method according to the present invention;

FIG. 6 is a graph comparing performance in a simulation between the proposed concatenated LDGM code and the conventional concatenated LDGM code; and

FIG. 7 is a graph comparing performance in a simulation between the proposed concatenated LDGM code and the conventional concatenated LDGM code.

A method for encoding/decoding a concatenated LDGM code according to the present invention will now be described with reference to the accompanying drawings.

The concatenated LDGM code encoding/decoding method according to the present invention generates an inner LDGM code by extending an outer LDGM code and uses an inner LDGM decoder in decoding the outer LDGM code. The inner LDGM decoder can be modified when necessary.

The present invention defines an outer LDGM code as an ($n_1$, $n_1$-k, p) regular LDGM code, and defines an inner LDGM code as an ($n_2$, $n_2$-k, rp) regular code. Herein, $n_1$ and $n_2$ denote lengths of the outer LDGM code and the inner LDGM code, respectively; $n_1$-k and $n_2$-k denote the number of parity check equations for the outer LDGM code and the inner LDGM code, respectively; and p and rp denote the number of edges of each bit node in a systematic part of a parity check matrix for the outer LDGM code and the inner LDGM code, respectively. Herein, k denotes the number of systematic bits, and r and s= $n_1/(n_1$_k) are natural numbers. The concatenated LDGM code encoding/decoding method according to the present invention first generates a parity check matrix of an outer LDGM code with a pseudorandom algorithm, and then generates a parity check matrix of an inner LDGM code by extending each row of the parity check matrix of the outer LDGM code to s rows. Herein, the number of edges of each bit node increases r-fold. For convenience of description, the parity check matrix of the outer LDGM code will be referred to as an "outer parity check matrix" and the parity check matrix of the inner LDGM code will be referred to as an "inner parity check matrix."

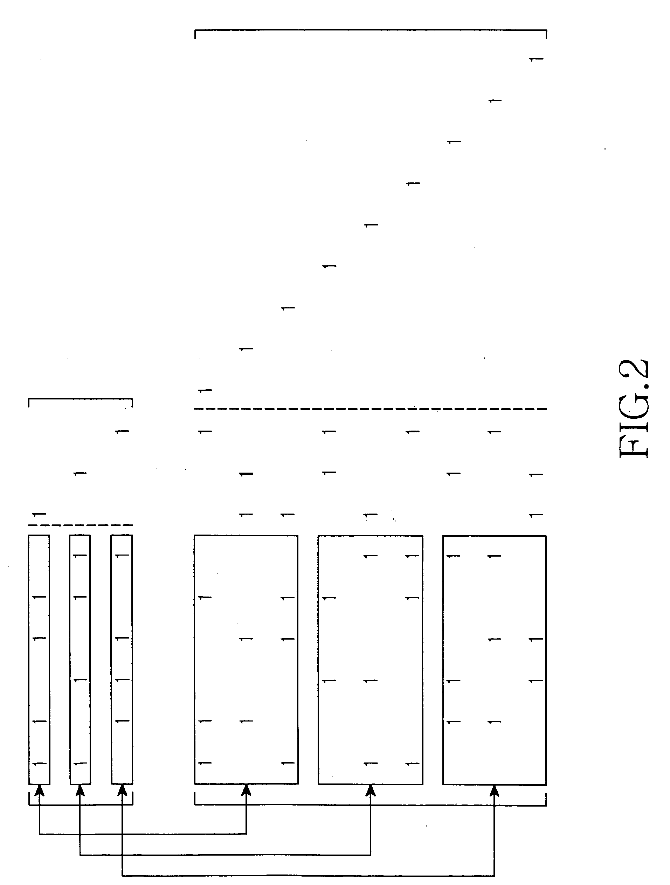

FIG. 2 is a conceptual diagram for a description of an LDGM code encoding/decoding method according to the present invention. An embodiment of the present invention will be described with reference to a (9, 3, 2) outer LDGM code and an (18, 9, 4) inner LDGM code.

In FIG. 2, an outer parity check matrix is divided into a systematic bit part corresponding to systematic bits in the left-hand side of a dotted line and a parity check part corresponding to parity bits in the right-hand side of the dotted line. Each row of the systematic bit part of the outer parity check matrix is extended to 3 rows. In this case, the number of edges of each bit node increases twofold. In this extension process, a progressive edge growth (PEG) algorithm can be used for performance maximization. The other region of the systematic bit part, constituting a parity check matrix of an inner LDGM code, can be generated with the pseudorandom algorithm.

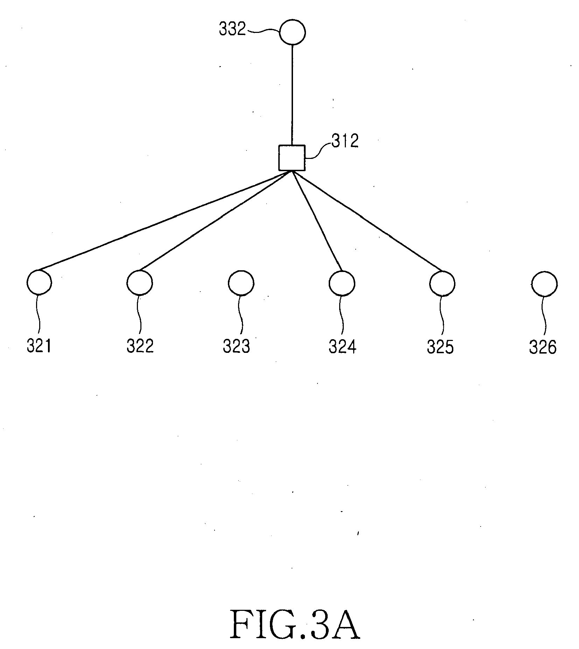

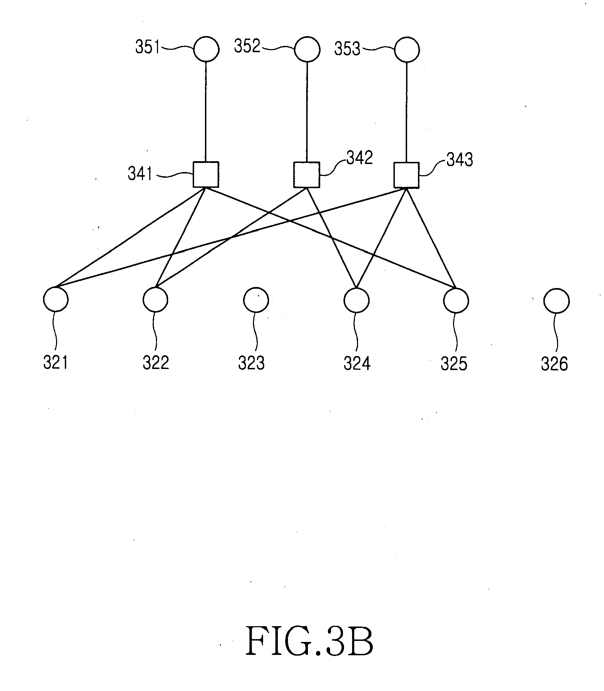

FIG. 3A is a bipartite graph for a first row of the systematic bit part of the outer parity check matrix shown in FIG. 2, and FIG 3B is a bipartite graph for the matrix generated by extending the first row of the systematic bit part of the outer parity check matrix shown in FIG. 2.

In FIG. 3A, a check node 312 is connected to 1st, 2nd, 4th and 5th bit nodes 321, 322, 324 and 325, and one coded bit node 332. According to the present invention, if a first row of the systematic bit part is extended to a 3-row matrix component and the matrix component generated through extension is expressed with a bipartite graph, three check nodes 341, 342 and 343 are generated and one of coded bit nodes 351, 352 and 353 is connected to each of the check nodes as shown in FIG 3B. The first check node 341 is connected to the 1st, 2nd and 5th bit node 321, 322 and 325; the second check node 342 is connected to the 2nd and 4th bit nodes 322 and 324; and the third check node 343 is connected to the 1st, 4th and 5th bit nodes 321, 324 and 325.

In the decoding process, if the extended check nodes constituting the parity check matrix of the inner LDGM code are integrated into a new check node, the result becomes equal to a check node of a parity check matrix of the outer LDGM code.

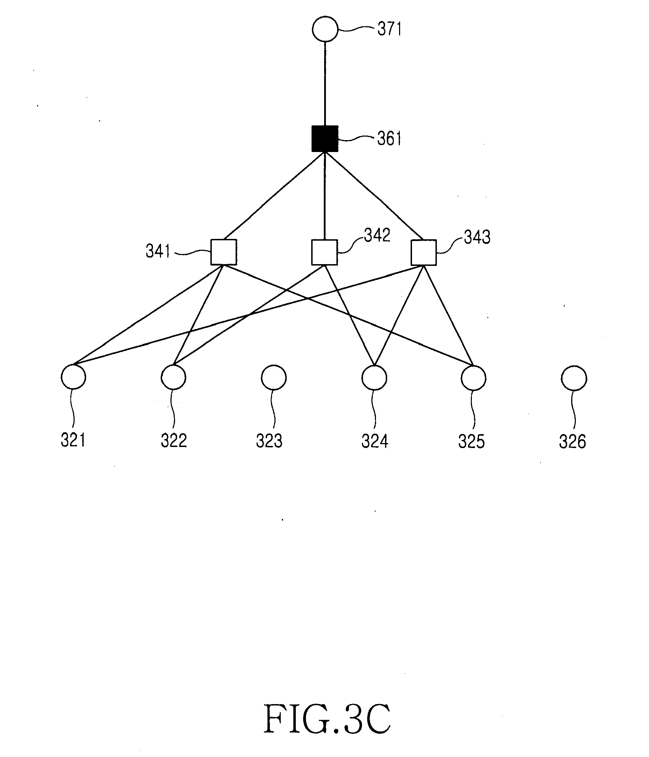

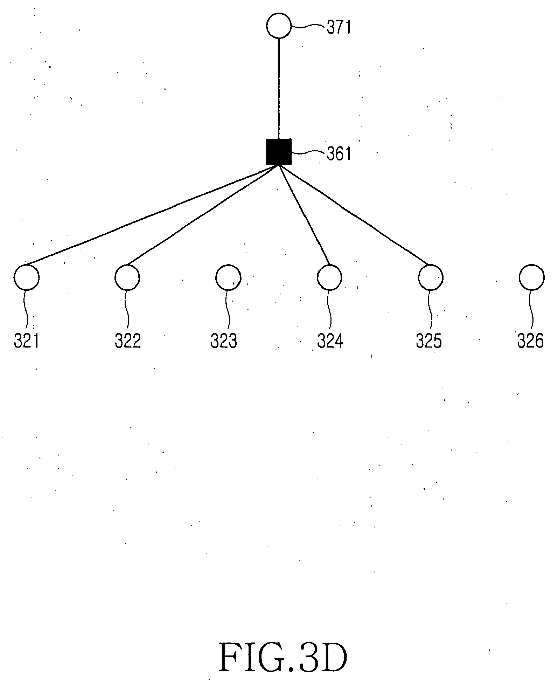

FIGs. 3C and 3D are conceptual diagrams of a process of integrating the check codes extended in the bipartite graph of FIG. 3B. If one dummy check node 361 is added and coded nodes are combined with one coded bit node 371 as shown in FIG 3C and then the extended check nodes are integrated into the dummy node 361 as shown in FIG. 3D, the result becomes equal to the bipartite graph of FIG. 3A.

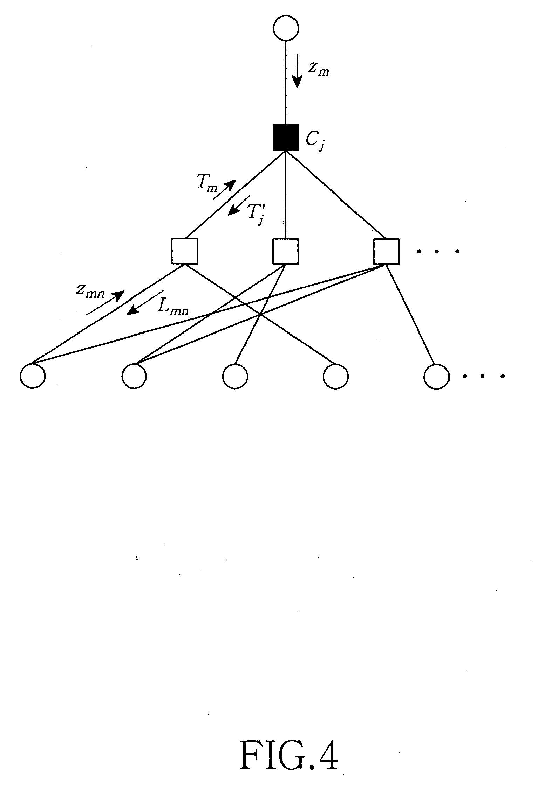

If a belief-propagation algorithm is modified by designing an inner code from a given code as described above, an inner decoder can be used during decoding of an outer code. FIG 4 is a conceptual diagram illustrating an improved belief-propagation algorithm applied to an LDGM code encoding/decoding method according to the present invention.

Generally, a check node message of the belief-propagation algorithm is updated in accordance with Equation (3) through Equation (5).

$$T_m = \prod_{n' \in N(m)} \frac{1 - \exp(z_{mn'})}{1 + \exp(z_{mn'})} \qquad \ldots \ldots \ldots \ldots (3)$$

$$T_{mn} = T_m \times \frac{1 - \exp(z_m)}{1 + \exp(z_m)} \bigg/ \frac{1 - \exp(z_{mn})}{1 + \exp(z_{mn})} \qquad \ldots \ldots \ldots \ldots (4)$$

$$L_{mn} = \ln \frac{1 - T_{mn}}{1 + T_{mn}} \qquad \cdots \cdots \cdots \cdots (5)$$

In Equation (3) through Equation (5), $N(m)$ denotes a set of bit nodes connected to a check node m except for a bit node with a column weight of l, $z_{mn}$ denotes a priori probability of a bit node n associated with the check node m, expressed in log-likelihood ratio, and $z_m$ denotes a priori probability of the bit node with a column weight of l at the check node m, expressed in log-likelihood ratio. A bit node message update rule can be expressed as Equation 6:

$$z_{mn} = F_n + \sum_{m' \in M(n) \backslash m} L_{m'n} \qquad \cdots \cdots \cdots \cdots (6)$$

where $F_n$ denotes a priori probability received at a receiver of a bit node n, expressed in log-likelihood ratio (LLR), and $M(n) \backslash m$ denotes a set of check nodes connected to a bit node n, except for a check node m.

To decode a concatenated LDGM code, the present invention first decodes an inner code using an inner decoder and then decodes an outer code after applying a slight modification to the same decoder.

If a set of inner check nodes extended from a check node j of an outer code is denoted by $S(j)$ and a new check node (dummy check node) included in $S(j)$ is denoted by $C_j$, then Equation (7) can be derived from Equation (3) and Equation (4) at $C_j$.

$$T'_j = \left( \prod_{m \in S(j)} T_m \right)^{1/r} \qquad \cdots \cdots \cdots \cdots (7)$$

In Equation (7), because the number of edges between inner bit nodes is r times larger than the number of edges between outer bit codes, the same message propagated from the bit nodes to the dummy check node $C_j$ is multiplied by a square of r. Therefore, an r$^{th}$ route given in Equation (5) must be taken at the dummy check node $C_j$. Thereafter, Equation (4) and Equation (5) are equal to each other except that $T_m$ is replaced with $T'_j$. For the bit node message update rule, because the same messages from the dummy check node $C_j$ are added at every bit node r times, Equation (6) is modified as Equation (8).

$$z_{mn} = F_n + \frac{1}{r} \times \sum_{m' \in M(n) \backslash m} L_{m'n} \qquad \cdots \cdots \cdots \cdots (8)$$

As described above, application of the LDGM code encoding/decoding method according to an embodiment of the present invention can reduce the decoder complexity. It is preferable to install a bit interleaver between an inner encoder and an outer encoder to improve performance of the LDGM code.

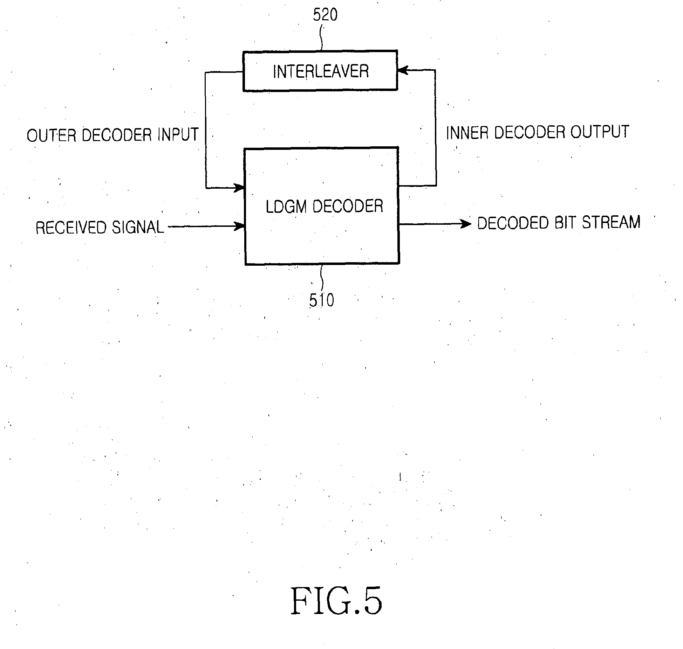

FIG. 5 is a block diagram schematically illustrating a structure of a concatenated LDGM decoder implemented by applying an LDGM code encoding/decoding method according to the present invention.

Unlike the conventional concatenated LDGM decoder which includes an inner decoder and an outer decoder, a new LDGM decoder according to the present invention includes an inner decoder and an interleaver. As illustrated in FIG. 5, an output bit stream of an inner decoder 510 is input back to the inner decoder 510 after being interleaved by an interleaver 520. The interleaved output is equal to an input to the conventional outer decoder. As a result, the present invention decodes both outer and inner codes with one decoder. By applying the structure of the decoder to the encoder in the same way, it is possible to implement an encoder with low complexity.

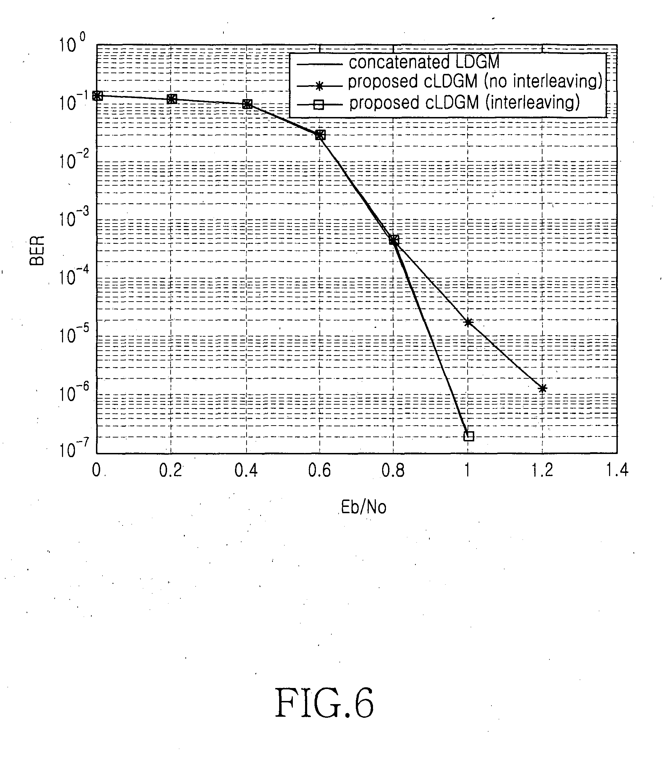

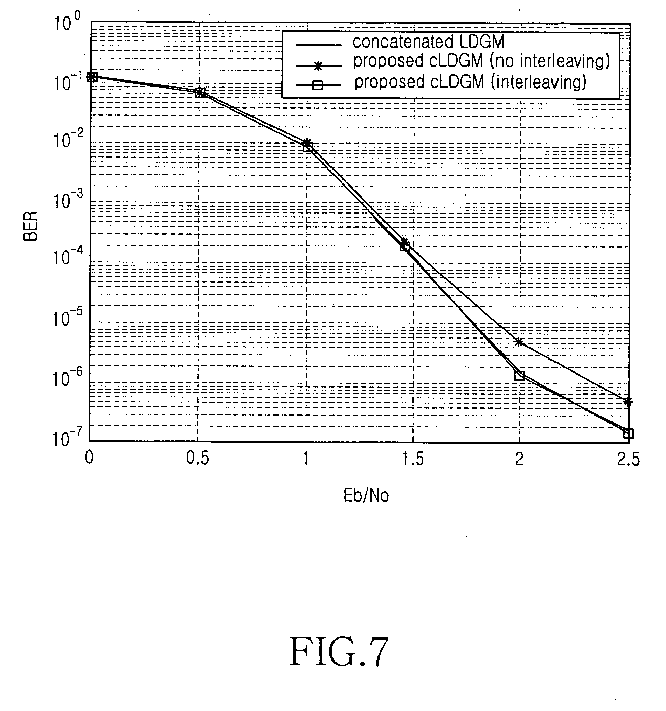

FIGs. 6 and 7 are graphs comparing performance in a simulation between the proposed concatenated LDGM code and the conventional concatenated LDGM code.

For the simulation, a (20000, 10000, 6) inner code with a coding rate of 0.5 and a (10000, 500, 3) outer code with a coding rate of 0.95 were used in an additive White Gaussian noise (AWGN) channel environment, and the same outer code was used for both the conventional concatenated LDGM code and the proposed concatenated LDGM code. The inner code for the conventional concatenated LDGM code was created using the PEG algorithm, and the proposed inner code was created by extending the outer coder according to the present invention.

It can be noted from FIG. 6 that when interleaving is applied at a Bit Error Rate (BER) of $10^{-5}$, the proposed concatenated LDGM code and the conventional concatenated LDGM code show almost similar performance.

FIG. 7, which is a performance curve for a concatenated LDGM code with a codeword length of 2000, shows a similar result to that of FIG. 6. As a result, application of the proposed concatenated LDGM code can obtain the almost similar performance to that of the conventional concatenated LDGM code using only one decoder.

As can be understood from the foregoing description, the concatenated LDGM code encoding/decoding method according to the present invention can decode an outer code with one inner decoder during implementation of a decoder because it generates an inner LDGM code from an outer LDGM code by extending each row of a parity check matrix of the outer LDGM code, thereby contributing to a reduction in decoding complexity.

While the invention has been shown and described with reference to a certain embodiment thereof, it will be understood by those skilled in the art that various changes in form and details may be made therein without departing from the scope of the invention as defined by the appended claims.

**Claims**

1. A decoding method in a concatenated low-density generator matrix, LDGM, code-based transmission system for detecting a signal using a parity check matrix including a systematic bit part mapped to systematic bits and a parity check part mapped to parity bits, the method comprising the steps of:

   generating an outer code parity check matrix with a predetermined size using a pseudorandom algorithm;
   generating an inner code parity check matrix using the outer code parity check matrix; and
   decoding a received signal using the inner code parity check matrix.

2. The decoding method of claim 1, wherein the outer code parity check matrix generating step comprises:

   generating a first systematic bit part with a predetermined size using the pseudorandom algorithm; and
   adding a first parity check part in the form of an identity matrix with the same row size, to the first systematic bit part.

3. The decoding method of claim 2, wherein the inner code parity check matrix generating step comprises:

   extending each row of the first systematic bit part of the outer code parity check matrix to a partial matrix with a predetermined row size;
   extending the first parity check part using the pseudorandom algorithm;
   generating a second systematic bit part of the inner code parity check matrix by arranging the extended partial matrixes and the extended first parity check parts; and
   adding a second parity check part in the form of an identity matrix with the same row size, to the second systematic bit part.

4. The decoding method of claim 3, wherein the first systematic bit part is extended using a progressive edge growth algorithm.

5. An encoding method in a concatenated low-density generator matrix, LDGM, code-based transmission system for detecting a signal using a parity check matrix including a systematic bit part mapped to systematic bits and a parity check part mapped to parity bits, the method comprising:

   generating an outer code parity check matrix with a predetermined size using a pseudorandom algorithm;
   generating an inner code parity check matrix using the outer code parity check matrix;
   generating a generator matrix using the inner code parity check matrix; and
   concatenatively-encoding a transmission signal using the generator matrix.

6. The encoding method of claim 5, wherein the outer code parity check matrix generating step comprises:

generating a first systematic bit part with a predetermined size using the pseudorandom algorithm; and
adding a first parity check part in the form of an identity matrix with the same row size, to the first systematic bit part.

7. The encoding method of claim 6, wherein the inner code parity check matrix generating step comprises:

extending each row of the first systematic bit part of the outer code parity check matrix to a partial matrix with a predetermined row size;
extending the first parity check part using the pseudorandom algorithm;
generating a second systematic bit part of the inner code parity check matrix by arranging the extended partial matrixes and the extended first parity check parts; and
adding a second parity check part in the form of an identity matrix with the same row size, to the second systematic bit part thereby to generate an inner code parity check matrix.

8. The encoding method of claim 7, wherein the first systematic bit part is extended using a progressive edge growth algorithm.

9. An encoding method in a concatenated low-density generator matrix, LDGM, code-based transmission system for detecting a signal using a parity check matrix including a systematic bit part mapped to systematic bits and a parity check part mapped to parity bits, the method comprising:

generating an outer code parity check matrix with a predetermined size using a pseudorandom algorithm;
generating an inner code parity check matrix using the outer code parity check matrix;
generating an inner generator matrix using the inner code parity check matrix;
generating an outer generator matrix using the outer code parity check matrix; and
concatenatively-encoding a transmission signal using the generator matrixes.

10. The encoding method of claim 9, wherein the outer code parity check matrix generating step comprises:

generating a first systematic bit part with a predetermined size using the pseudorandom algorithm; and
adding a first parity check part in the form of an identity matrix with the same row size, to the first systematic bit part thereby to generate an outer code parity check matrix.

11. The encoding method claim 10, wherein the inner code parity check matrix generating step comprises:

extending each row of the first systematic bit part of the outer code parity check matrix to a partial matrix with a predetermined row size;
extending the first parity check part using the pseudorandom algorithm;
generating a second systematic bit part of the inner code parity check matrix by arranging the extended partial matrixes and the extended first parity check parts; and
adding a second parity check part in the form of an identity matrix with the same row size, to the second systematic bit part thereby to generate an inner code parity check matrix.

12. The encoding method of claim 11, wherein the first systematic bit part is extended using a progressive edge growth algorithm.

13. A low-density generator matrix, LDGM, decoder in a concatenated LDGM code-based transmission system using an inner LDGM code and an outer LDGM code,
wherein the LDGM decoder groups a plurality of parity check nodes constituting a parity check matrix of the inner LDGM code and uses the parity check node groups as check nodes of the parity check matrix.

14. The LDGM decoder of claim 13, wherein the parity check matrix of the outer LDGM code comprises:

a first systematic bit part with a predetermined size, generated using a pseudorandom algorithm; and
a first parity check part having the same row size as that of the first systematic bit part.

15. The LDGM decoder of claim 14, wherein the parity check matrix of the inner LDGM code comprises:

a second systematic bit part including first partial matrixes generated by extending each row of the first systematic bit part in a predetermined size and second partial matrixes generated by extending the first parity check matrix using a pseudorandom algorithm; and
a second parity check part in the form of an identity matrix having the same row size as that of the second systematic bit part.

16. The LDGM decoder of claim 15, wherein each row of the first systematic bit part is extended using a progressive edge growth algorithm.

17. The LDGM decoder of claim 13, further comprising an interleaver for interleaving an output signal of the decoder and feeding the interleaved signal back to the decoder.

FIG.1

FIG.2

332 ○

312

□

321  322  323  324  325  326
○    ○    ○    ○    ○    ○

# FIG.3A

FIG.3B

FIG.3C

FIG.3D

FIG.4

520

INTERLEAVER

OUTER DECODER INPUT

INNER DECODER OUTPUT

LDGM DECODER

RECEIVED SIGNAL ⟶

⟶ DECODED BIT STREAM

510

FIG.5

FIG.6

FIG.7

European Patent
Office

**EUROPEAN SEARCH REPORT**

Application Number

EP 06 00 7306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | JOON-SUNG KIM ET AL: "Concatenated LDGM codes with single decoder" IEEE COMMUNICATIONS LETTERS IEEE USA, vol. 10, no. 4, April 2006 (2006-04), pages 287-289, XP002397441 ISSN: 1089-7798 * the whole document * | 1-17 | INV. H03M13/11 H03M13/29 |
| X | GARCIA-FRIAS J ET AL: "APPROACHING SHANNON PERFORMANCE BY ITERATIVE DECODING OF LINEAR CODES WITH LOW-DENSITY GENERATOR MATRIX" IEEE COMMUNICATIONS LETTERS, IEEE SERVICE CENTER, PISCATAWAY, NJ, US, vol. 7, no. 6, June 2003 (2003-06), pages 266-268, XP001163859 ISSN: 1089-7798 * the whole document * | 1,2,5,6, 9,10 | |
| X | HANQING LOU ET AL: "Low-density generator matrix codes for indoor and Markov channels" GLOBAL TELECOMMUNICATIONS CONFERENCE, 2004. GLOBECOM '04. IEEE DALLAS, TX, USA 29 NOV.-3 DEC., 2004, PISCATAWAY, NJ, USA,IEEE, vol. 1, 29 November 2004 (2004-11-29), pages 498-502, XP010758938 ISBN: 0-7803-8794-5 * the whole document * | 1,2,5,6, 9,10 | TECHNICAL FIELDS SEARCHED (IPC)  H03M |

-/--

The present search report has been drawn up for all claims

| Place of search | Date of completion of the search | Examiner |
|---|---|---|
| Munich | 5 September 2006 | Barel-Faucheux, C |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**European Patent Office**

## EUROPEAN SEARCH REPORT

Application Number

EP 06 00 7306

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHONG W ET AL: "LDGM codes for joint source-channel coding of correlated sources" PROCEEDINGS 2003 INTERNATIONAL CONFERENCE ON IMAGE PROCESSING. ICIP-2003. BARCELONA, SPAIN, SEPT. 14 - 17, 2003, INTERNATIONAL CONFERENCE ON IMAGE PROCESSING, NEW YORK, NY : IEEE, US, vol. VOL. 2 OF 3, 14 September 2003 (2003-09-14), pages 593-596, XP010670184 ISBN: 0-7803-7750-8 * the whole document * | 1,2,5,6, 9,10 | |
| X | GARCIA-FRIAS J ET AL INSTITUTE OF ELECTRICAL AND ELECTRONICS ENGINEERS: "Iterative decoding schemes for source and joint source-channel coding of correlated sources" CONFERENCE RECORD OF THE 36TH. ASILOMAR CONFERENCE ON SIGNALS, SYSTEMS, & COMPUTERS. PACIFIC GROOVE, CA, NOV. 3 - 6, 2002, ASILOMAR CONFERENCE ON SIGNALS, SYSTEMS AND COMPUTERS, NEW YORK, NY : IEEE, US, vol. VOL. 1 OF 2. CONF. 36, 3 November 2002 (2002-11-03), pages 250-256, XP010638211 ISBN: 0-7803-7576-9 * the whole document * | 1,2,5,6, 9,10 | TECHNICAL FIELDS SEARCHED (IPC) |

-----

-----

-/--

The present search report has been drawn up for all claims

| Place of search | Date of completion of the search | Examiner |
|---|---|---|
| Munich | 5 September 2006 | Barel-Faucheux, C |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 
& : member of the same patent family, corresponding
   document

EPO FORM 1503 03.82 (P04C01)

European Patent
Office

**EUROPEAN SEARCH REPORT**

Application Number

EP 06 00 7306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HU X-Y ET AL: "PROGRESSIVE EDGE-GROWTH TANNER GRAPHS" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY : IEEE, US, vol. VOL. 2 OF 6, 25 November 2001 (2001-11-25), pages 995-1001, XP001099254 ISBN: 0-7803-7206-9 * the whole document * | 1-17 | |
| P,A | CHEN Z ET AL: "CONSTRUCTION OF LOW-DENSITY PARITY-CHECK CONVOLUTIONAL CODES THROUGH PROGRESSIVE EDGE-GROWTH" December 2005 (2005-12), IEEE COMMUNICATIONS LETTERS, IEEE SERVICE CENTER, PISCATAWAY, NJ, US, PAGE(S) 1058-1060 , XP001237858 ISSN: 1089-7798 * the whole document * | 1-17 | TECHNICAL FIELDS SEARCHED (IPC) |

The present search report has been drawn up for all claims

| Place of search | Date of completion of the search | Examiner |
|---|---|---|
| Munich | 5 September 2006 | Barel-Faucheux, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)